# EUROPEAN PATENT SPECIFICATION

(11) **EP 3 105 851 B1**
(45) Date of publication and mention of the grant of the patent: **25.04.2018**
(21) Application number: 15706999.8
(22) Date of filing: 12.02.2015
(51) Int. Cl.: H03F 3/189, H03F 3/191, H03F 1/02, H03F 3/193, H03G 3/00, H04B 1/40, H04W 52/02, H04W 88/06

(54) **CURRENT-EFFICIENT LOW NOISE AMPLIFIER (LNA)**
STROMEFFIZIENTER RAUSCHARMER VERSTÄRKER (LNA)
AMPLIFICATEUR À FAIBLE BRUIT À RENDEMENT DE COURANT

(30) Priority: 14.02.2014 US 201414180434
(43) Date of publication of application: 21.12.2016
(73) Proprietor: Qualcomm Incorporated, San Diego, CA 92121-1714 (US)
(72) Inventor: HASSAN, Muhammad, San Diego, California 92121 (US); TANG, Yiwu, San Diego, California 92121 (US); VAN ZALINGE, Klaas, San Diego, California 92121 (US); WANG, Chuan, San Diego, California 92121 (US); PAN, Dongling, San Diego, California 92121 (US)
(74) Representative: Wagner & Geyer
(86) International application number: PCT/US2015/015518
(87) International publication number: WO 2015/123368

(56) References cited:
- WO-A1-2013/025953
- WO-A2-2008/112789
- US-A1- 2008 258 817
- US-A1- 2011 068 871
- US-A1- 2014 015 607
- US-B1- 8 442 473
- MA YUELIN ET AL: "Adaptive Compensation of Inter-Band Modulation Distortion for Tunable Concurrent Dual-Band Receivers", IEEE TRANSACTIONS ON MICROWAVE THEORY AND TECHNIQUES, IEEE SERVICE CENTER, PISCATAWAY, NJ, US, vol. 61, no. 12, 1 December 2013 (2013-12-01), pages 4209-4219, XP011532005, ISSN: 0018-9480, DOI: 10.1109/TMTT.2013.2288088 [retrieved on 2013-11-28]
- PARK CHESTER ET AL: "Carrier aggregation for LTE-advanced: design challenges of terminals", IEEE COMMUNICATIONS MAGAZINE, IEEE SERVICE CENTER, PISCATAWAY, US, vol. 51, no. 12, 1 December 2013 (2013-12-01), pages 76-84, XP011534261, ISSN: 0163-6804, DOI: 10.1109/MCOM.2013.6685761 [retrieved on 2013-12-16]

## Description

### BACKGROUND

### Field

The present disclosure relates generally to electronics, and more specifically to transmitters and receivers.

### Background

In a radio frequency (RF) transceiver, a communication signal is developed, upconverted, amplified and transmitted by a transmitter and is received, amplified, downconverted and recovered by a receiver. In the receiver, the communication signal is typically received and downconverted by receive circuitry including a filter, an amplifier, a mixer, and other components, to recover the information contained in the communication signal. A single transmitter or receiver can be configured to operate using multiple transmit frequencies and/or multiple receive frequencies. For a receiver to be able to simultaneously receive two or more receive signals, the concurrent operation of two or more receive paths is used. Such systems are sometimes referred to as "carrier-aggregation" (CA) systems. The term "carrier-aggregation" may refer to systems that include inter-band carrier aggregation (Inter-CA) and intra-band carrier aggregation (Intra-CA). Intra-CA refers to the processing of two or more separate (either contiguous or non-contiguous) carrier signals that occur in the same communication band. The carrier aggregated RF signal is typically down-converted using two or more distinct local oscillator (LO) frequencies, which generally employs a low noise amplifier (LNA) having a single RF input and multiple RF outputs to process the multiple carriers present in the Intra-CA RF signal. State-of-the art LNAs use a cascode device diverter switching architecture to support Intra-CA, but such an architecture consumes a large amount of current when supporting multiple carriers, and becomes impractical for three or more carrier signals.

Therefore, in Intra-CA receiver systems, it would be desirable to reduce the amount of current consumed by the LNA when operating on multiple carrier signals.

Attention is drawn to the document WO 2013/025953, which describes multiple low noise amplifiers (LNAs) with combined outputs. In an exemplary design, an apparatus includes a front-end module and an integrated circuit (IC). The front-end module includes a plurality of LNAs having outputs that are combined. The IC includes receive circuits coupled to the plurality of LNAs via a single interconnection. In an exemplary design, each of the plurality of LNAs may be enabled or disabled via a respective control signal for that LNA. The front-end module may also include receive filters coupled to the plurality of LNAs and a switchplexer coupled to the receive filters. The front-end module may further include at least one power amplifier, and the IC may further include transmit circuits coupled to the at least one power amplifier.

In accordance with the present invention a device and a method as set forth in the independent claims, is provided. Embodiments of the invention are claimed in the dependent claims.

### BRIEF DESCRIPTION OF THE DRAWINGS

In the figures, like reference numerals refer to like parts throughout the various views unless otherwise indicated. For reference numerals with letter character designations such as "102a" or "102b", the letter character designations may differentiate two like parts or elements present in the same figure. Letter character designations for reference numerals may be omitted when it is intended that a reference numeral encompass all parts having the same reference numeral in all figures.
FIG. 1 is a diagram showing a wireless device communicating with a wireless communication system.
FIG. 2A is a graphical diagram showing an example of contiguous intra-band carrier-aggregation (CA).
FIG. 2B is a graphical diagram showing an example of non-contiguous intra-band CA.
FIG. 2C is a graphical diagram showing an example of inter-band CA in the same band group.
FIG. 2D is a graphical diagram showing an example of inter-band CA in different band groups.
FIG. 3 is a block diagram of an exemplary design of the wireless device in FIG. 1.
FIG. 4 is a schematic diagram illustrating an exemplary embodiment of a receiver front-end having a current-efficient low noise amplifier (LNA).
FIG. 5 is a schematic diagram illustrating an alternative exemplary embodiment of a receiver front-end having a current-efficient low noise amplifier (LNA).
FIG. 6 is a flow chart describing the operation of an exemplary embodiment of a method for processing a signal in a current-efficient low noise amplifier.

### DETAILED DESCRIPTION

The word "exemplary" is used herein to mean "serving as an example, instance, or illustration." Any aspect described herein as "exemplary" is not necessarily to be construed as preferred or advantageous over other aspects.

In this description, the term "application" may also include files having executable content, such as: object code, scripts, byte code, markup language files, and patches. In addition, an "application" referred to herein, may also include files that are not executable in nature, such as documents that may need to be opened or other data files that need to be accessed.

The term "content" may also include files having executable content, such as: object code, scripts, byte code, markup language files, and patches. In addition, "content" referred to herein, may also include files that are not executable in nature, such as documents that may need to be opened or other data files that need to be accessed.

As used herein, the terms "transducer" and "transducer element" refer to an antenna element that can be stimulated with a feed current to radiate electromagnetic energy, and an antenna element that can receive electromagnetic energy and convert the received electromagnetic energy to a receive current that is applied to receive circuitry.

As used herein, the terms "jammer," "jammer signal," "interfering signal," "TX jammer," and "TX jammer signal" refer to any signal received by receive circuitry that desensitizes the receiver, or that interferes with or hinders the reception and recovery of an information signal received in a receiver.

Exemplary embodiments of the disclosure are directed toward a current-efficient low noise amplifier (LNA) circuit that uses a single first amplification stage for single-carrier processing, and that uses a single first amplifier stage and two or more amplification paths in a second amplifier stage for multiple-carrier processing. The amplification paths in the second amplifier stage consume significantly less current than the first amplifier stage. Multiple iterations of the amplification paths in the second amplifier stage are used for multiple carrier processing.

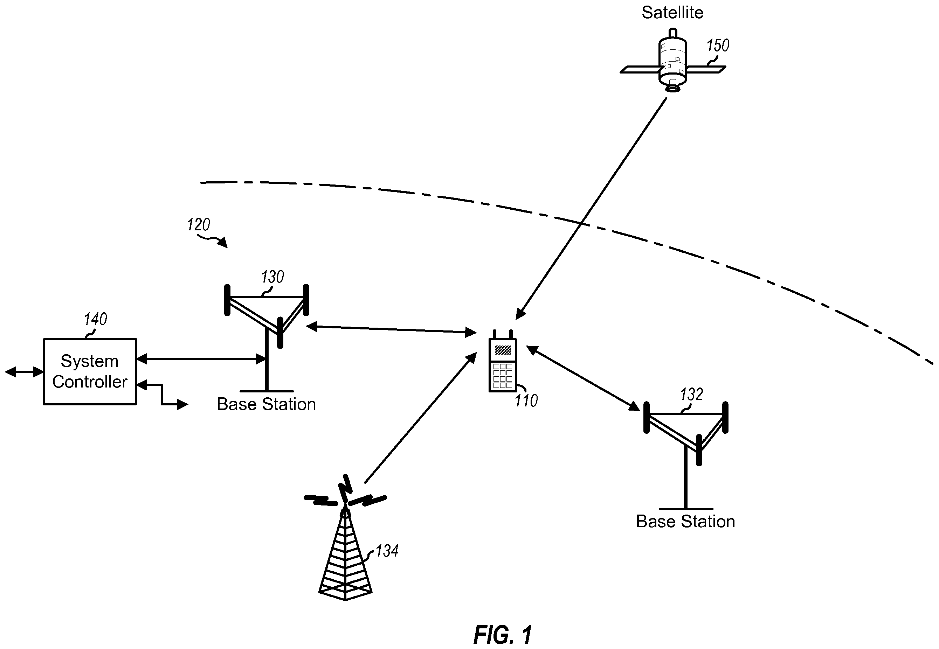

FIG. 1 is a diagram showing a wireless device 110 communicating with a wireless communication system 120. The wireless communication system 120 may be a Long Term Evolution (LTE) system, a Code Division Multiple Access (CDMA) system, a Global System for Mobile Communications (GSM) system, a wireless local area network (WLAN) system, or some other wireless system. A CDMA system may implement Wideband CDMA (WCDMA), CDMA IX, Evolution-Data Optimized (EVDO), Time Division Synchronous CDMA (TD-SCDMA), or some other version of CDMA. For simplicity, FIG. 1 shows wireless communication system 120 including two base stations 130 and 132 and one system controller 140. In general, a wireless communication system may include any number of base stations and any set of network entities.

The wireless device 110 may also be referred to as a user equipment (UE), a mobile station, a terminal, an access terminal, a subscriber unit, a station, etc. Wireless device 110 may be a cellular phone, a smartphone, a tablet, a wireless modem, a personal digital assistant (PDA), a handheld device, a laptop computer, a smartbook, a netbook, a tablet, a cordless phone, a wireless local loop (WLL) station, a Bluetooth device, etc. Wireless device 110 may communicate with wireless communication system 120. Wireless device 110 may also receive signals from broadcast stations (e.g., a broadcast station 134), signals from satellites (e.g., a satellite 150) in one or more global navigation satellite systems (GNSS), etc. Wireless device 110 may support one or more radio technologies for wireless communication such as LTE, WCDMA, CDMA IX, EVDO, TD-SCDMA, GSM, 802.11, etc.

Wireless device 110 may support carrier aggregation, which is operation on multiple carriers. Carrier aggregation may also be referred to as multi-carrier operation. Wireless device 110 may be able to operate in low-band (LB) covering frequencies lower than 1000 megahertz (MHz), mid-band (MB) covering frequencies from 1000 MHz to 2300 MHz, and/or high-band (HB) covering frequencies higher than 2300 MHz. For example, low-band may cover 698 to 960 MHz, mid-band may cover 1475 to 2170 MHz, and high-band may cover 2300 to 2690 MHz and 3400 to 3800 MHz. Low-band, mid-band, and high-band refer to three groups of bands (or band groups), with each band group including a number of frequency bands (or simply, "bands"). Each band may cover up to 200 MHz and may include one or more carriers. Each carrier may cover up to 20 MHz in LTE. LTE Release 11 supports 35 bands, which are referred to as LTE/UMTS bands and are listed in 3GPP TS 36.101. Wireless device 110 may be configured with up to five carriers in one or two bands in LTE Release 11.

In general, carrier aggregation (CA) may be categorized into two types - intra-band CA and inter-band CA. Intra-band CA refers to operation on multiple carriers within the same band. Inter-band CA refers to operation on multiple carriers in different bands.

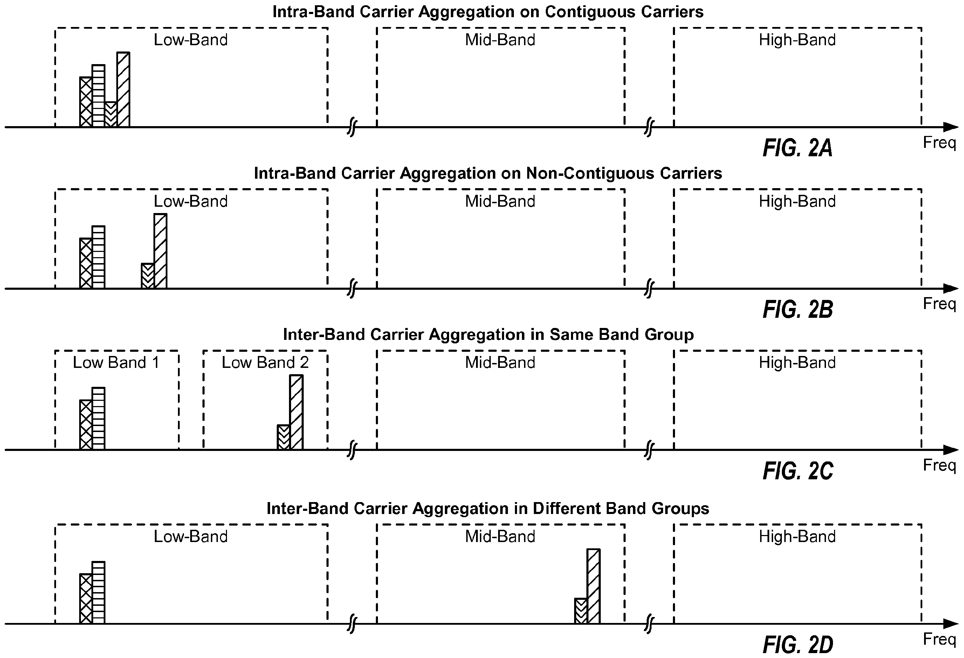

FIG. 2A is a graphical diagram showing an example of contiguous intra-band carrier-aggregation (CA). In the example shown in FIG. 2A, wireless device 110 is configured with four contiguous carriers in one band in low-band. Wireless device 110 may send and/or receive transmissions on the four contiguous carriers within the same band.

FIG. 2B is a graphical diagram showing an example of non-contiguous intra-band CA. In the example shown in FIG. 2B, wireless device 110 is configured with four non-contiguous carriers in one band in low-band. The carriers may be separated by 5 MHz, 10 MHz, or some other amount. Wireless device 110 may send and/or receive transmissions on the four non-contiguous carriers within the same band.

FIG. 2C is a graphical diagram showing an example of inter-band CA in the same band group. In the example shown in FIG. 2C, wireless device 110 is configured with four carriers in two bands in low-band. Wireless device 110 may send and/or receive transmissions on the four carriers in different bands in the same band group.

FIG. 2D is a graphical diagram showing an example of inter-band CA in different band groups. In the example shown in FIG. 2D, wireless device 110 is configured with four carriers in two bands in different band groups, which include two carriers in one band in low-band and two carriers in another band in mid-band. Wireless device 110 may send and/or receive transmissions on the four carriers in different bands in different band groups.

FIGS. 2A to 2D show four examples of carrier aggregation. Carrier aggregation may also be supported for other combinations of bands and band groups.

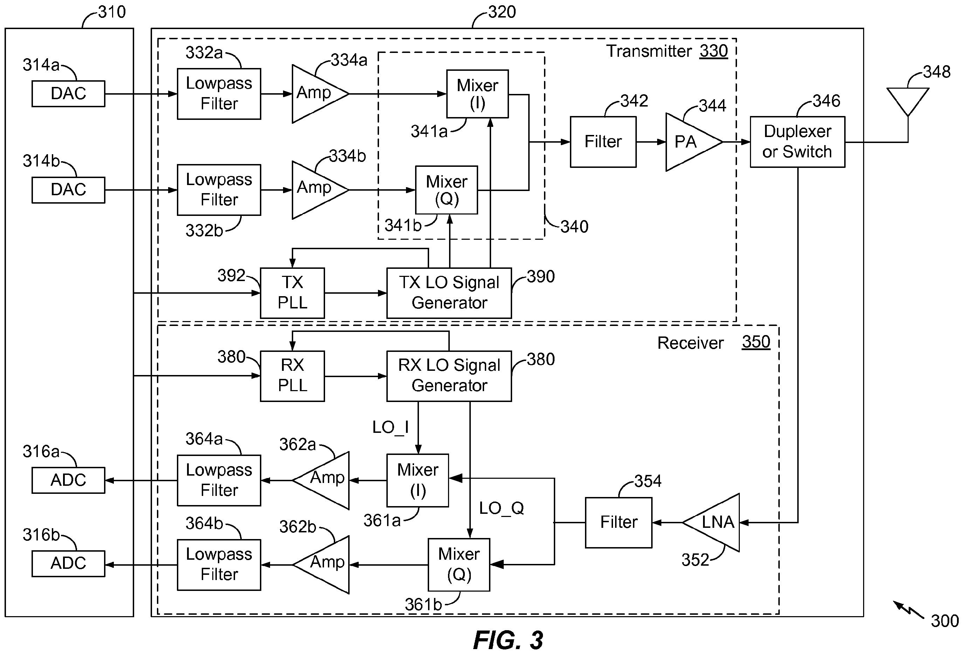

FIG. 3 is a block diagram showing a wireless communication device 300 in which the exemplary techniques of the present disclosure may be implemented. FIG. 3 shows an example of a transceiver 300. In general, the conditioning of the signals in a transmitter 330 and a receiver 350 may be performed by one or more stages of amplifier, filter, upconverter, downconverter, etc. These circuit blocks may be arranged differently from the configuration shown in FIG. 3. Furthermore, other circuit blocks not shown in FIG. 3 may also be used to condition the signals in the transmitter and receiver. Unless otherwise noted, any signal in FIG. 3, or any other figure in the drawings, may be either single-ended or differential. Some circuit blocks in FIG. 3 may also be omitted.

In the example shown in FIG. 3, wireless device 300 generally comprises a transceiver 320 and a data processor 310. The data processor 310 may include a memory (not shown) to store data and program codes, and may generally comprise analog and digital processing elements. The transceiver 320 includes a transmitter 330 and a receiver 350 that support bi-directional communication. In general, wireless device 300 may include any number of transmitters and/or receivers for any number of communication systems and frequency bands. All or a portion of the transceiver 320 may be implemented on one or more analog integrated circuits (ICs), RF ICs (RFICs), mixed-signal ICs, etc.

A transmitter or a receiver may be implemented with a super-heterodyne architecture or a direct-conversion architecture. In the super-heterodyne architecture, a signal is frequency-converted between radio frequency (RF) and baseband in multiple stages, e.g., from RF to an intermediate frequency (IF) in one stage, and then from IF to baseband in another stage for a receiver. In the direct-conversion architecture, a signal is frequency converted between RF and baseband in one stage. The super-heterodyne and direct-conversion architectures may use different circuit blocks and/or have different requirements. In the example shown in FIG. 3, transmitter 330 and receiver 350 are implemented with the direct-conversion architecture.

In the transmit path, the data processor 310 processes data to be transmitted and provides in-phase (I) and quadrature (Q) analog output signals to the transmitter 330. In an exemplary embodiment, the data processor 310 includes digital-to-analog-converters (DAC's) 314a and 314b for converting digital signals generated by the data processor 310 into the I and Q analog output signals, e.g., I and Q output currents, for further processing.

Within the transmitter 330, lowpass filters 332a and 332b filter the I and Q analog transmit signals, respectively, to remove undesired images caused by the prior digital-to-analog conversion. Amplifiers (Amp) 334a and 334b amplify the signals from lowpass filters 332a and 332b, respectively, and provide I and Q baseband signals. An upconverter 340 upconverts the I and Q baseband signals with I and Q transmit (TX) local oscillator (LO) signals from a TX LO signal generator 390 and provides an upconverted signal. A filter 342 filters the upconverted signal to remove undesired images caused by the frequency upconversion as well as noise in a receive frequency band. A power amplifier (PA) 344 amplifies the signal from filter 342 to obtain the desired output power level and provides a transmit RF signal. The transmit RF signal is routed through a duplexer or switch 346 and transmitted via an antenna 348.

In the receive path, antenna 348 receives communication signals and provides a received RF signal, which is routed through duplexer or switch 346 and provided to a low noise amplifier (LNA) 352. The duplexer 346 is designed to operate with a specific RX-to-TX duplexer frequency separation, such that RX signals are isolated from TX signals. The received RF signal is amplified by LNA 352 and filtered by a filter 354 to obtain a desired RF input signal. Downconversion mixers 361a and 361b mix the output of filter 354 with I and Q receive (RX) LO signals (i.e., LO_I and LO_Q) from an RX LO signal generator 380 to generate I and Q baseband signals. The I and Q baseband signals are amplified by amplifiers 362a and 362b and further filtered by lowpass filters 364a and 364b to obtain I and Q analog input signals, which are provided to data processor 310. In the exemplary embodiment shown, the data processor 310 includes analog-to-digital-converters (ADC's) 316a and 316b for converting the analog input signals into digital signals to be further processed by the data processor 310.

In FIG. 3, TX LO signal generator 390 generates the I and Q TX LO signals used for frequency upconversion, while RX LO signal generator 380 generates the I and Q RX LO signals used for frequency downconversion. Each LO signal is a periodic signal with a particular fundamental frequency. A phase locked loop (PLL) 392 receives timing information from data processor 310 and generates a control signal used to adjust the frequency and/or phase of the TX LO signals from LO signal generator 390. Similarly, a PLL 382 receives timing information from data processor 310 and generates a control signal used to adjust the frequency and/or phase of the RX LO signals from LO signal generator 380.

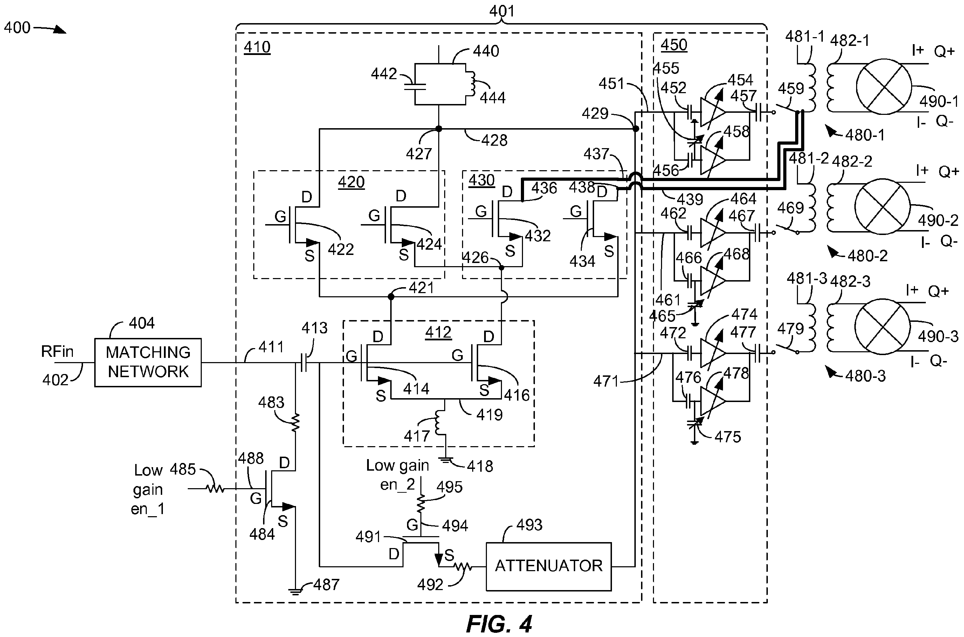

FIG. 4 is a schematic diagram illustrating an exemplary embodiment of a receiver front-end 400 having an exemplary embodiment of a current-efficient low noise amplifier (LNA) 401. In an exemplary embodiment, the LNA 401 shown in FIG. 4 describes a single-ended implementation of the LNA 352 shown in FIG. 3.

The receiver front-end 400 comprises a matching circuit 404 configured to receive a radio frequency input signal (RFin) on connection 402. The RFin signal on connection 402 may comprise a single carrier, or may comprise multiple carriers in an intra-CA communication system. The receiver front-end 400 also comprises an exemplary embodiment of a current-efficient LNA 401, load circuits 480-1, 480-2 and 480-3, and mixers 490-1, 490-2 and 490-3. The load circuits 480-1 through 480-3 and the mixers 490-1 through 490-3 correspond to the number of carrier signals processed by the receiver front-end 400, with each carrier signal processed by one load circuit 480 and one mixer 490. In this exemplary embodiment, the three load circuits and the three mixers are configured to process up to three carrier signals. More or fewer carrier signals can be processed by implementing more or fewer load circuits and mixers. The load circuits 480 provide single-ended to differential signal conversion and the mixers 490 provide the "true" or "+" and "complement" or "-" components of the differential In-phase (I+ and I-) and quadrature (Q+ and Q-) receive signals. Although a single mixer 490 is shown in FIG. 4, two iterations of each mixer 490 would be implemented to provide the differential I+, Q+, I- and Q- receive signals.

In an exemplary embodiment, the current-efficient LNA 401 comprises a first amplifier stage 410 and a second amplifier stage 450. The first amplifier stage 410 comprises a gain stage 412 and cascode stages 420 and 430. The gain stage 412 comprises a transistor 414 and a transistor 416. In an exemplary embodiment, the transistor 414 is a 1/3 wide device and the transistor 416 is a 2/3 wide device, where the designations 1/3 and 2/3 refer to the physical size of the device, which corresponds to the current handling capability of the device. For example, in this exemplary embodiment, 1/3 of the current flowing through the gain stage 412will flow through the transistor 414 and 2/3 of the current flowing through the gain stage 412 will flow through the transistor 416.

A source of the transistor 414 and a source of the transistor 416 are coupled to a source degeneration inductor 417. The source degeneration inductor 417 is coupled to ground 418.

The cascode stage 420 comprises a transistor 422 and a transistor 424. The transistor 422 is a 1/3 wide device and the transistor 424 is a 2/3 wide device. The drain of the transistor 422 and the drain of the transistor 424 are coupled to a node 427, which forms the output of the cascode circuit 420, and which is provided to a resonator circuit 440. The resonator circuit 440 is also referred to herein as a tank circuit. In an exemplary embodiment, the resonator circuit 440 comprises a capacitance 442 and an inductance 444. In an exemplary embodiment, the inductance 444 is a low-Q inductor. In alternative exemplary embodiments, the resonator circuit 440 can be implemented with additional components to create a higher order filter that can filter out-of-band jammer signals. The source of the transistor 422 is coupled to the drain of the transistor 414 at node 421. The source of the transistor 424 is coupled to the drain of the transistor 416 at node 426.

The cascode stage 430 comprises a transistor 432 and a transistor 434. The transistor 432 is a 1/3 wide device and the transistor 434 is a 2/3 wide device. The drain of the transistor 432 and the drain of the transistor 434 are coupled to respective bypass connections 437 and 439, which, in an exemplary embodiment, bypass the second amplifier stage 450 and which are coupled to a primary side 481-1 of the load circuit 480-1. The source of the transistor 432 is coupled to the drain of the transistor 416 at node 426. The source of the transistor 434 is coupled to the drain of the transistor 414 at node 421.

The RFin signal is provided from the matching network 404 over connection 411 to the gate of the transistor 414 and to the gate of the transistor 416.

In an exemplary embodiment, the second amplifier stage 450 comprises a plurality of amplification paths, each amplification path configured to process one carrier signal. A first amplification path 451 comprises a capacitor 452 coupled to a high-gain low input impedance (low-Z) buffer 454, a capacitor 456, and a variable capacitance 455 coupled to a low-gain high input impedance (high-Z) buffer 458. The output of the high-gain low-Z buffer 454 and an output of the low-gain high-Z buffer 458 are coupled to a capacitance 457. The capacitance 457 is coupled to the load circuit 480-1 through a switch 459. The high-gain low-Z buffer 454, the low-gain high-Z buffer 458 and the switch 459 can be controlled by a signal or signals provided by an analog or a digital processing element (not shown).

In an exemplary embodiment, the high-gain low-Z buffer 454 and the low-gain high-Z buffer 458 comprise transconductance (gm) stages that convert the voltage output of the cascode stage 420 to a current that is provided to the load circuit 480-1.

A second amplification path 461 comprises a capacitor 462 coupled to a high-gain low-Z buffer 464, a capacitor 466, and a variable capacitance 465 coupled to a low-gain high-Z buffer 468. The output of the high-gain low-Z buffer 464 and an output of the low-gain high-Z buffer 468 are coupled to a capacitance 467. The capacitance 467 is coupled to the load circuit 480-2 through a switch 469. The high-gain low-Z buffer 464, the low-gain high-Z buffer 468 and the switch 469 can be controlled by a signal or signals provided by an analog or a digital processing element (not shown).

A third amplification path 471 comprises a capacitor 472 coupled to a high-gain low-Z buffer 474, a capacitor 476, and a variable capacitance 475 coupled to a low-gain high-Z buffer 478. The output of the high-gain low-Z buffer 474 and an output of the low-gain high-Z buffer 478 is coupled to a capacitance 477. The capacitance 477 is coupled to the load circuit 480-3 through a switch 479. The high-gain low-Z buffer 474, the low-gain high-Z buffer 478 and the switch 479 can be controlled by a signal or signals provided by an analog or a digital processing element (not shown).

The low-gain, high-Z buffers 458, 468 and 478 have a gain (voltage to current conversion) that is lower than the gain of the high-gain, low-Z buffers 454, 464 and 474. Similarly, the low-gain, high-Z buffers 458, 468 and 478 have an input impedance (Z) that is higher than an in input impedance of the high-gain, low-Z buffers 454, 464 and 474. The higher input impedance of the low-gain, high-Z buffers 458, 468 and 478 relative to the high-gain, low-Z buffers 454, 464 and 474 is achieved by making the capacitances 456, 466 and 476 smaller (by a factor of 10, for example) than the capacitances 452, 462 and 472, respectively, resulting in a 10:1 input impedance ratio between the low-gain, high-Z buffers 458, 468 and 478 and the high-gain, low-Z buffers 454, 464 and 474. In this manner, a wide gain dynamic range can be obtained without excessively loading the node 427.

In an exemplary embodiment, assume that each of the high-gain, low-Z buffers 454, 464, 474, and the low-gain, high-Z buffers 458, 468 and 478 can provide a gain range from 0 to 10 dB. To extend the gain range to a target gain range of, for example, 20 dB, an additional 10 dB attenuation can be obtained by reducing the value of the capacitances 456, 466 and 476 relative to the capacitances 452, 462 and 472, respectively, by a factor of 10 in this exemplary embodiment. In an exemplary embodiment, this can be accomplished by using the variable capacitances 455, 465 and 475 to further control the capacitance at the input to the low-gain, high-Z buffers 458, 468 and 478, respectively. In this manner, the low-gain, high-Z buffers 458, 468 and 478 would provide 10dB attenuation, but by reducing the value of their respective capacitances 456, 466 and 476, relative to the capacitances 452, 462 and 472, the overall gain dynamic range is expanded to a range of 0-20 dB. In an exemplary embodiment, the variable capacitances 455, 465 and 475 can each be a digitally controlled capacitor bank configured to receive a control signal (not shown).

In another exemplary embodiment, the gain range could be further expanded by adding another lower gain buffer in parallel with the high-gain, low-Z buffer 454 and the low-gain, high-Z buffer 458, having even higher input impedance than the low gain high-Z buffer 458. The second amplification path 461 and the third amplification path 471 can similarly include an additional parallel lower gain buffer, as described above.

Each of the high-gain, low-Z buffers 454, 464, and 474 and the low-gain, high-Z buffers 458, 468, 478 can be implemented as three complementary metal oxide semiconductor (CMOS) inverters coupled in parallel, and can be turned on and off independently by a digital control signal (not shown) to achieve a different gain. The high fixed impedance offered by the capacitances 456, 466 and 476, allows the implementation of the digitally-controlled variable capacitances 455, 465 and 475 at the inputs to the low-gain, high-Z buffers 458,468 and 478, respectively, without loading node 427.

In this exemplary embodiment, each of the three amplification paths 451, 461 and 471 is configured to process one of up to three carrier signals. More or fewer carrier signals can be processed by implementing more or fewer amplification paths.

In an exemplary embodiment, the gain stage 412 amplifies the RFin signal on connection 411 and provides the amplified receive signal on nodes 421 and 426. Depending on the number of carrier signals in the RFin communication signal, either the cascode stage 420 or the cascode stage 430 is activated to process the amplified RFin communication signal provided on nodes 421 and 426.

### Single carrier

If the RFin communication signal at nodes 421 and 426 comprises a single carrier, then the cascode stage 420 is deactivated and the cascode stage 430 is activated and the RFin communication signal is provided directly from the drain of the transistor 432 at node 436 and from the drain of the transistor 434 at node 438 over respective connections 437 and 439 directly to the primary side 481-1 of the load circuit 480-1, thus bypassing the second amplifier stage 450. In this exemplary embodiment, the cascode sage 430 provides a current directly to the primary side 481-1 of the load circuit 480-1.

### Intra-CA (multiple carrier)

If the RFin communication signal at nodes 421 and 426 comprises multiple carriers in an intra-CA communication mode, then the cascode stage 430 is deactivated and the cascode stage 420 is activated and the RFin communication signal is provided to the resonator circuit 440 via the node 427. The resonator circuit 440 converts the current output of the cascode stage 420 to a voltage, and provides the voltage to the second amplifier stage 450 via the connection 428 and the node 429.

In this exemplary embodiment, the multiple carriers are processed by the multiple amplifier paths in the second amplifier stage 450. Each of the amplification paths 451, 461 and 471 is a low-power consuming transconductance (gm) stage, which, in an exemplary embodiment, consumes a small amount of current compared to the gain stage 412 and the cascode stage 420 or the cascade stage 430. In this manner, multiple carrier signals can be processed by the second amplifier stage 450 without implementing multiple gain stages in the first amplifier stage 410. In an exemplary embodiment, the combined gain stage 412 and cascade stage 420 may consume on the order of 10 milliamperes (mA), while each amplifier path 451, 461, 471 in the second amplifier stage 450 may consume approximately 2-3 mA.

In this intra-CA communication mode in which the amplified Rfin signal is provided to the node 429, one or more of the amplification paths 451, 461 and 471 is configured to process one of up to three carrier signals. For example, a first carrier signal may be processed by the amplification path 451, a second carrier signal may be processed by the amplification path 461 and a third carrier signal may be processed by the amplification path 471.

In an exemplary embodiment, a first carrier signal may be provided to the first amplification path 451, where either of the high-gain low-Z buffer 454 or the low-gain high-Z buffer 458 operates on the signal and provides the carrier signal through the capacitor 457, through the switch 459 to the primary side 481-1 of the load circuit 480-1. The load circuit 480-1 provides single-ended to differential signal conversion, and provides differential signals from the secondary side 482-1 of the load circuit 480-1 to the mixer 490-1. The mixer 490-1 downconverts the first carrier and provides the differential I and Q components of the first carrier signal.

In an exemplary embodiment, a second carrier signal may be provided to the second amplification path 461, where either of the high-gain low-Z buffer 464 or the low-gain high-Z buffer 468 operates on the signal and provides the second carrier signal through the capacitor 467, through the switch 469 to the primary side 481-2 of the load circuit 480-2. The load circuit 480-2 provides single-ended to differential signal conversion, and provides differential signals from the secondary side 482-2 of the load circuit 480-2 to the mixer 490-2. The mixer 490-2 downconverts the second carrier and provides the differential I and Q components of the second carrier signal.

In an exemplary embodiment, a third carrier signal may be provided to the third amplification path 471, where either of the high-gain low-Z buffer 474 or the low-gain high-Z buffer 478 operates on the signal and provides the third carrier signal through the capacitor 477, through the switch 479 to the primary side 481-3 of the load circuit 480-3. The load circuit 480-3 provides single-ended to differential signal conversion, and provides differential signals from the secondary side 482-3 of the load circuit 480-3 to the mixer 490-3. The mixer 490-3 downconverts the third carrier and provides the differential I and Q components of the third carrier signal.

In this manner, multiple carriers can be efficiently processed from a current-consumption perspective by the single first amplifier stage 410 and multiple iterations of amplification paths in the second amplifier stage 450, without using a first amplifier stage to individually process each carrier in an intra-CA mode. Further, existing single-carrier operation is maintained by having the ability to process a single carrier in the first amplifier stage 410 while bypassing the second amplifier stage 450, as described above.

The first amplifier stage 410 also comprises a transistor 484 configured to receive a gain control input signal at its gate 488 through a resistance 485 in a first low gain mode. The drain of the transistor 484 is connected to the RFin signal output from the matching network 404 on connection 411 through a resistance 483. The source of the transistor 484 is connected to a ground 487. The gain control signal on connection 488 is enabled only when any or all of the transistor 414 (the 1/3 size device), the transistor 422 (the 1/3 size device) and the transistor 432 (the 1/3 size device)is on, which causes the transistor 484 to become conductive and to connect the connection 411 to ground 487 via a resistor 483, which helps in maintaining the matching as well as the linearity by lowering the quality factor of the impedance at the input node 411 in a first low-gain low-power mode.

The first amplifier stage 410 also comprises a switch 491 configured to receive gain control input signal at its gate 494 through a resistance 495 in a second low gain mode. The gain control input signal on the gate 494 causes an input signal, RFin to bypass the first amplifier stage 412 and sends the Rfin signal (after attenuation provided by the attenuator 493) to the second amplifier stage 450 via node 429. Therefore, when the level of the incoming receive signal Rfin is large, the high gain provided by the first amplifier stage 412 is bypassed to prevent its desensitization and only the low gain second amplifier stage 450 is enabled. In this manner, the second amplifier stage 450 is reused for this second low gain LNA mode instead of requiring an additional separate low gain LNA.

The attenuation provided by the attenuator 493 depends on the level of a jammer at the input 411. If a jammer having a level that could desensitize the second amplification stage 450 is received at the input 411, then a controller (not shown) would signal the attenuator 493to keep increasing the attenuation until the Rfin signal can be processed (without de-sensitization) by the subsequent stages (mixer, baseband filter, etc.). In this manner a good signal-to-noise ratio can be ensured over a wide dynamic range.

In an exemplary embodiment, the cascode stage 420 and the cascode stage 430 in the first amplifier stage 410 can be independently optimized for single carrier processing (cascode stage 430) and for multiple carrier processing (cascode stage 420) in an intra-CA mode.

The gain, noise figure (NF), and linearity of the LNA 401 is not degraded in intra-CA mode because the first amplifier stage remains at fixed current and therefore a constant gain, matching and NF is guaranteed, irrespective of the number of CA paths being enabled.

In an exemplary embodiment, the resonator circuit 440 can be implemented with a higher order filter to improve out of band harmonic rejection

The two-stage architecture provides improved isolation (S12>-40 dB), which leads to smaller LO leakage.

In an exemplary embodiment, an on-chip AC coupling capacitor 413 can be implemented because the matching does not change between a single-carrier mode of operation and a multi-carrier mode of operation, as the bias point and therefore the input impedance of the first amplifier stage 412 remains the same irrespective of the number of carriers being enabled

In addition, circuit routing optimization is possible because routing can be distributed between the first amplifier stage 410 and the second amplifier stage 450; and between the second amplifier stage 450 and the load circuits 480-1 through 480-3.

A single degeneration inductor 417 can be used, which makes it more robust to longer ground routing connections, although it could be replaced by a resistor at the cost of NF and gain degradation.

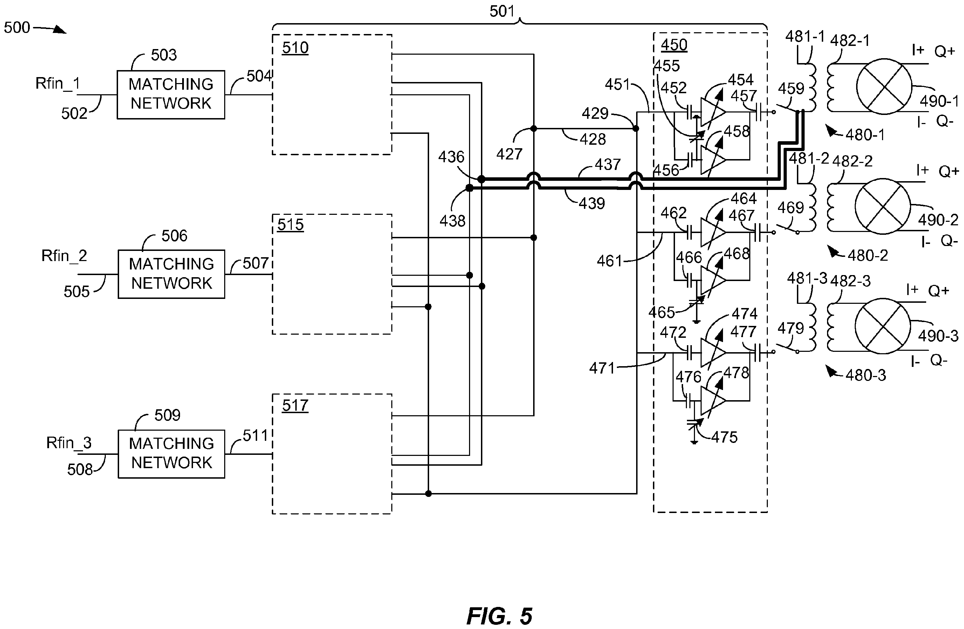

FIG. 5 is a schematic diagram 500 illustrating an alternative exemplary embodiment of a receiver front-end having a current-efficient low noise amplifier. The receiver front-end 500 comprises a first matching circuit 503 configured to receive a first radio frequency input signal (RFin_1) on connection 502; a second matching circuit 506 configured to receive a second radio frequency input signal (RFin_2) on connection 505; and a third matching circuit 509 configured to receive a third radio frequency input signal (RFin_3) on connection 508. The RFin signals RFin_1, RFin_2 and RFin_3 on connections 502, 505 and 508 may comprise multiple carriers in an intra-CA communication system. The receiver front-end 500 also comprises an exemplary embodiment of a current-efficient LNA 501, load circuits 480-1, 480-2 and 480-3, and mixers 490-1, 490-2 and 490-3. The load circuits 480-1 through 480-3 and the mixers 490-1 through 490-3 correspond to the number of carrier signals processed by the receiver front-end 400, with each carrier signal processed by one load circuit 480 and one mixer 490, as described above. In this exemplary embodiment, the three load circuits and the three mixers are configured to process up to three carrier signals. More or fewer carrier signals can be processed by implementing more or fewer load circuits and mixers.

In an exemplary embodiment, the current-efficient LNA 501 comprises a plurality of first amplifier stages 510, 515, and 517, each of which is similar to the first amplifier stage 410 described in FIG. 4. Each of the first amplifier stages 510, 515, and 517 is coupled to a respective matching circuit 503, 506 and 509 over respective couplings 504, 507 and 511. Each of the first amplifier stages 510, 515, and 517 can be operatively coupled to the second amplifier stage 450, so that the first amplifier stages 510, 515, and 517 all share the second amplifier stage 450.

In this exemplary embodiment, the second amplifier stage 450 is shared among the multiple first amplifier stages 510, 515, and 517, where each of the first amplifier stages 510, 515 and 517 is matched to a different frequency/band, by the respective matching circuits 503, 506 and 509. In this exemplary embodiment, the second amplifier stage 450 can be re-used for the different frequency/bands associated with the three input signals RFin_1, RFin_2 and RFin_3.

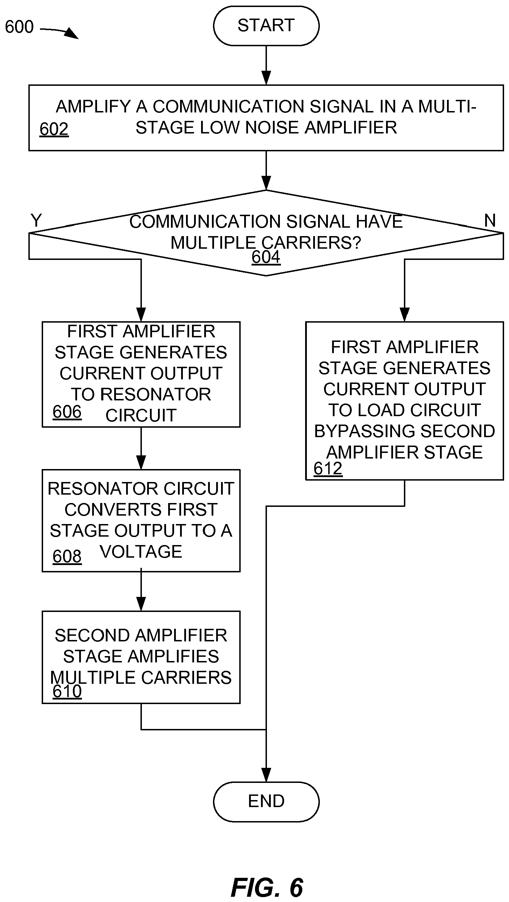

FIG. 6 is a flow chart describing the operation of an exemplary embodiment of a method for processing a signal in a current-efficient low noise amplifier.

In block 602, a communication signal is amplified in a multi-stage low noise amplifier.

In block 604, it is determined whether the communication has multiple carriers.

If the communication signal has multiple carriers, then, in block 606, the first amplifier stage generates a current output to the resonator circuit 440.

In block 608, the resonator circuit 440 converts the current to a voltage.

In block 610, the second amplifier stage amplifies the multiple carriers.

If the communication signal has a single carrier, then, in block 612, the first amplifier stage generates a current output directly to the load circuit 480-1, bypassing the second amplifier stage.

The current-efficient low noise amplifier described herein may be implemented on one or more ICs, analog ICs, RFICs, mixed-signal ICs, ASICs, printed circuit boards (PCBs), electronic devices, etc. The current-efficient low noise amplifier may also be fabricated with various IC process technologies such as complementary metal oxide semiconductor (CMOS), N-channel MOS (NMOS), P-channel MOS (PMOS), bipolar junction transistor (BJT), bipolar-CMOS (BiCMOS), silicon germanium (SiGe), gallium arsenide (GaAs), heterojunction bipolar transistors (HBTs), high electron mobility transistors (HEMTs), silicon-on-insulator (SOI), etc.

An apparatus implementing the current-efficient low noise amplifier described herein may be a stand-alone device or may be part of a larger device. A device may be (i) a stand-alone IC, (ii) a set of one or more ICs that may include memory ICs for storing data and/or instructions, (iii) an RFIC such as an RF receiver (RFR) or an RF transmitter/receiver (RTR), (iv) an ASIC such as a mobile station modem (MSM), (v) a module that may be embedded within other devices, (vi) a receiver, cellular phone, wireless device, handset, or mobile unit, (vii) etc.

In one or more exemplary designs, the functions described may be implemented in hardware, software, firmware, or any combination thereof. If implemented in software, the functions may be stored on or transmitted over as one or more instructions or code on a computer-readable medium. Computer-readable media includes both computer storage media and communication media including any medium that facilitates transfer of a computer program from one place to another. A storage media may be any available media that can be accessed by a computer. By way of example, and not limitation, such computer-readable media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Also, any connection is properly termed a computer-readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, includes compact disc (CD), laser disc, optical disc, digital versatile disc (DVD), floppy disk and blu-ray disc where *disks* usually reproduce data magnetically, while *discs* reproduce data optically with lasers. Combinations of the above should also be included within the scope of computer-readable media.

As used in this description, the terms "component," "database," "module," "system," and the like are intended to refer to a computer-related entity, either hardware, firmware, a combination of hardware and software, software, or software in execution. For example, a component may be, but is not limited to being, a process running on a processor, a processor, an object, an executable, a thread of execution, a program, and/or a computer. By way of illustration, both an application running on a computing device and the computing device may be a component. One or more components may reside within a process and/or thread of execution, and a component may be localized on one computer and/or distributed between two or more computers. In addition, these components may execute from various computer readable media having various data structures stored thereon. The components may communicate by way of local and/or remote processes such as in accordance with a signal having one or more data packets (*e.g.*, data from one component interacting with another component in a local system, distributed system, and/or across a network such as the Internet with other systems by way of the signal).

## Claims

1. A device (400, 500), comprising:
a multi-mode low noise amplifier, LNA, (401, 501) having a first amplifier stage (410) and having a single-carrier mode and a carrier aggregation, CA, mode; and
a second amplifier stage (450) coupled to the first amplifier stage (410), the second amplifier stage (450) having a plurality of amplification paths (451, 461, 471) configured to amplify a plurality of carrier frequencies of a carrier-aggregated communication channel and provide a corresponding plurality of output signals at an LNA output when the first amplifier stage (410) is in the CA mode, the first amplifier stage (410) configured to bypass the second amplifier stage (450) to provide another output signal at the LNA output when the first amplifier stage (410) is in the single-carrier mode.

2. The device (400) of claim 1, wherein the first amplifier stage (410) is configured to generate a current output when the first amplifier stage (410) is in the single-carrier mode.

3. The device (400) of claim 1, further comprising a resonator circuit (440) configured to receive a current output of the first amplifier stage (410), the resonator circuit (440) configured to convert the current output to a voltage output, the voltage output provided to the plurality of amplification paths (451, 461, 471) in the second amplifier stage (450).

4. The device (400) of claim 1, wherein the plurality of amplification paths (451, 461, 471) in the second amplifier stage (450) comprise a plurality of adjustable gain stages.

5. The device (400) of claim 4, wherein at least one of the plurality of adjustable gain stages comprises an adjustable input capacitance (455).

6. The device (400) of claim 5, wherein the adjustable input capacitance (455) is configured to change an input impedance of the plurality of adjustable gain stages.

7. The device (500) of claim 1, further comprising a plurality of first amplifier stages (510, 515, 517) coupled to one second amplifier stage (450).

8. A method (600) comprising:
setting a mode of a multi-mode low noise amplifier, LNA, (401, 501) to a state indicating one of a single-carrier mode and a carrier aggregation, CA, mode;
amplifying (602) a communication signal in a first amplifier stage (410) of the multi-mode LNA (401, 501) ;
amplifying (610) a plurality of carrier frequencies of the communication signal using a plurality of amplifier paths (451, 461, 471) of a second amplifier stage (450) coupled to the first amplifier stage (410), and providing a corresponding plurality of output signals at an LNA output when the LNA (401, 501) is set to the CA mode; and
bypassing (612) the second amplifier stage (450) by the first amplifier stage (410) providing another output signal to the LNA output when the LNA (401, 501) is set to the single-carrier mode.

9. The method (600) of claim 8, wherein:
bypassing (612) the second amplifier stage (450) comprises generating a current in the first amplifier stage (410) when the communication signal comprises a single carrier in the single-carrier mode.

10. The method (600) of claim 8, further comprising:
generating (606) a current output of the first amplifier stage (410);
converting (608) the current output to a voltage output; and
amplifying (610) the voltage output in the plurality of amplifier paths (451, 461, 471) in the second amplifier stage (450).

## Patentansprüche

1. Eine Einrichtung (400, 500), die Folgendes aufweist:
einen rauscharmen Verstärker mit mehreren Modi bzw. Multi-Modus-LNA (LNA = low noise amplifier) (401, 501) mit einer ersten Verstärkerstufe (410) und mit einem Einzelträgermodus und einem Trägeraggregations- bzw. CA-Modus (CA = carrier aggregation); und
eine zweite Verstärkerstufe (450), die an die erste Verstärkerstufe (410) gekoppelt ist, wobei die zweite Verstärkerstufe (450) eine Vielzahl von Verstärkungspfaden (451, 461, 471) hat, die konfiguriert sind zum Verstärken einer Vielzahl von Trägerfrequenzen eines trägeraggregierten Kommunikationskanals und zum Vorsehen einer entsprechenden Vielzahl von Ausgangssignalen an einem LNA-Ausgang, wenn die erste Verstärkerstufe (410) in dem CA-Modus ist, wobei die erste Verstärkerstufe (410) konfiguriert ist zum Umgehen der zweiten Verstärkerstufe (450) zum Vorsehen eines anderen Ausgangssignals an dem LNA-Ausgang, wenn die erste Verstärkerstufe (410) in dem Einzelträgermodus ist.

2. Einrichtung (400) nach Anspruch 1, wobei die erste Verstärkerstufe (410) konfiguriert ist zum Generieren einer Stromausgabe, wenn die erste Verstärkerstufe (410) in dem Einzelträgermodus ist.

3. Einrichtung (400) nach Anspruch 1, die weiter eine Resonatorschaltung (440) aufweist, die konfiguriert ist zum Empfangen einer Stromausgabe der ersten Verstärkerstufe (410), wobei die Resonatorschaltung (440) konfiguriert ist zum Konvertieren der Stromausgabe in eine Spannungsausgabe, wobei die Spannungsausgabe an die Vielzahl von Verstärkungspfaden (451, 461, 471) in der zweiten Verstärkerstufe (450) geliefert wird.

4. Einrichtung (400) nach Anspruch 1, wobei die Vielzahl von Verstärkungspfaden (451, 461, 471) in der zweiten Verstärkerstufe (450) eine Vielzahl von einstellbaren Verstärkungsstufen aufweist.

5. Einrichtung (400) nach Anspruch 4, wobei wenigstens eine der Vielzahl von einstellbaren Verstärkungsstufen eine einstellbare Eingangskapazität (455) aufweist.

6. Einrichtung (400) nach Anspruch 5, wobei die einstellbare Eingangskapazität (455) konfiguriert ist zum Ändern einer Eingangsimpedanz der Vielzahl von einstellbaren Verstärkungsstufen.

7. Einrichtung (500) nach Anspruch 1, die weiter eine Vielzahl von ersten Verstärkerstufen (510, 515, 517) aufweist, die an eine zweite Verstärkerstufe (450) gekoppelt sind.

8. Ein Verfahren (600), das Folgendes aufweist:
Einstellen eines Modus eines rauscharmen Verstärkers mit mehreren Modi bzw. Multi-Modus-LNA (LNA = low noise amplifier) (401, 501) auf einen Zustand, der einen Einzelträgermodus und einen Trägeraggregations- bzw. CA-Modus (CA = carrier aggregation) anzeigt;
Verstärken (602) eines Kommunikationssignals in einer ersten Verstärkerstufe (410) des Multi-Modus-LNA (401, 501);
Verstärken (610) einer Vielzahl von Trägerfrequenzen des Kommunikationssignals unter Verwendung einer Vielzahl von Verstärkungspfaden (451, 461, 471) einer zweiten Verstärkerstufe (450), die an die erste Verstärkerstufe (410) gekoppelt ist und Vorsehen einer entsprechenden Vielzahl von Ausgangssignalen an einem LNA-Ausgang, wenn der LNA (401, 501) auf den CA-Modus eingestellt ist; und
Umgehen (612) der zweiten Verstärkerstufe (450) durch die erste Verstärkerstufe (410), was ein anderes Ausgangssignal an dem LNA-Ausgang vorsieht, wenn der LNA (401, 501) auf den Einzelträgermodus eingestellt ist.

9. Verfahren (600) nach Anspruch 8, wobei:
das Umgehen (612) der zweiten Verstärkerstufe (450) Generieren eines Stroms in der ersten Verstärkerstufe (410) aufweist, wenn das Kommunikationssignal einen Einzelträger in dem Einzelträgermodus aufweist.

10. Verfahren (600) nach Anspruch 8, das weiter Folgendes aufweist:
Generieren (606) einer Stromausgabe der ersten Verstärkerstufe (410);
Konvertieren bzw. Wandeln (608) der Stromausgabe in eine Spannungsausgabe; und
Verstärken (610) der Spannungsausgabe in der Vielzahl von Verstärkungspfaden (451, 461, 471) in der zweiten Verstärkerstufe (450).

## Revendications

1. Dispositif (400, 500), comprenant :
un amplificateur à faible bruit, LNA, multimode (401, 501) comportant un premier étage amplificateur (410) et ayant un mode à une seule porteuse et un mode à agrégation de porteuses, CA ; et
un deuxième étage amplificateur (450) couplé au premier étage amplificateur (410), le deuxième étage amplificateur (450) ayant une pluralité de chemins d'amplification (451, 461, 471) agencés pour amplifier une pluralité de fréquences porteuses d'un canal de communication à porteuses agrégées et fournir une pluralité correspondante de signaux de sortie au niveau d'une sortie de LNA lorsque le premier étage amplificateur (410) est dans le mode CA, le premier étage amplificateur (410) étant agencé pour contourner le deuxième étage amplificateur (450) pour fournir un autre signal de sortie au niveau de la sortie de LNA lorsque le premier étage amplificateur (410) est dans le mode à une seule porteuse.

2. Dispositif (400) selon la revendication 1, dans lequel le premier étage amplificateur (410) est agencé pour générer une sortie en courant lorsque le premier étage amplificateur (410) est dans le mode à une seule porteuse.

3. Dispositif (400) selon la revendication 1, comprenant en outre un circuit résonateur (440) agencé pour recevoir une sortie en courant du premier étage amplificateur (410), le circuit résonateur (440) étant agencé pour convertir la sortie en courant en une sortie en tension, la sortie en tension étant fournie à la pluralité de chemins d'amplification (451, 461, 471) dans le deuxième étage amplificateur (450).

4. Dispositif (400) selon la revendication 1, dans lequel la pluralité de chemins d'amplification (451, 461, 471) dans le deuxième étage amplificateur (450) comprend une pluralité d'étages à gain ajustable.

5. Dispositif (400) selon la revendication 4, dans lequel au moins l'un de la pluralité d'étages à gain ajustable comprend une capacité d'entrée ajustable (455).

6. Dispositif (400) selon la revendication 5, dans lequel la capacité d'entrée ajustable (450) est agencée pour modifier une impédance d'entrée de la pluralité d'étages à gain ajustable.

7. Dispositif (500) selon la revendication 1, comprenant en outre une pluralité de premiers étages amplificateurs (510, 515, 517) couplés à un deuxième étage amplificateur (450).

8. Procédé (600) comprenant :
régler un mode d'un amplificateur à faible bruit, LNA, multimode (401, 501) à un état indiquant l'un d'un mode à une seule porteuse et d'un mode à agrégation de porteuses, CA ;
amplifier (602) un signal de communication dans un premier étage amplificateur (410) du LNA multimode (401, 501) ;
amplifier (610) une pluralité de fréquences porteuses du signal de communication en utilisant une pluralité de chemins d'amplificateur (451, 461, 471) d'un deuxième étage amplificateur (450) couplé au premier étage amplificateur (410), et fournir une pluralité correspondante de signaux de sortie au niveau d'une sortie de LNA lorsque le LNA (401), 501) est réglé dans le mode CA ; et
contourner (612) le deuxième étage amplificateur (450) par le premier étage amplificateur (410) fournissant un autre signal de sortie à la sortie du LNA lorsque le LNA (401, 501) est réglé dans le mode à une seule porteuse.

9. Procédé (600) selon la revendication 8, dans lequel :
le contournement (612) du deuxième étage amplificateur (450) comprend la génération d'un courant dans le premier étage amplificateur (410) lorsque le signal de communication comprend une seule porteuse dans le mode à une seule porteuse.

10. Procédé (600) selon la revendication 8, comprenant en outre :
générer (606) une sortie en courant du premier étage amplificateur (410) ;
convertir (608) la sortie en courant en une sortie en tension ; et
amplifier (610) la sortie en tension dans la pluralité de chemins d'amplificateur (451, 461, 471) dans le deuxième étage amplificateur (450).
